# EUROPÄISCHE PATENTSCHRIFT

(11) **EP 3 231 010 B1**
(45) Veröffentlichungstag und Bekanntmachung des Hinweises auf die Patenterteilung: **03.03.2021**
(21) Anmeldenummer: 15781664.6
(22) Anmeldetag: 19.10.2015
(51) Int. Cl.: H01L 23/00, H03H 9/10, H04R 19/04

(54) **EINFACH HERSTELLBARES ELEKTRISCHES BAUELEMENT UND VERFAHREN ZUR HERSTELLUNG EINES ELEKTRISCHEN BAUELEMENTS**
SIMPLE TO PRODUCE ELECTRIC COMPONENT AND METHOD FOR PRODUCING AN ELECTRIC COMPONENT
COMPOSANT ÉLECTRIQUE FACILE À FABRIQUER ET PROCÉDÉ DE FABRICATION D'UN COMPOSANT ÉLECTRIQUE

(30) Priorität: 09.12.2014 DE 102014118214
(43) Veröffentlichungstag der Anmeldung: 18.10.2017
(73) Patentinhaber: SnapTrack, Inc., San Diego, CA 92121 (US)
(72) Erfinder: BAUER, Christian, 81737 München (DE); KRÜGER, Hans, 81737 München (DE); PORTMANN, Jürgen, 81677 München (DE); STELZL, Alois, 81549 München (DE); PAHL, Wolfgang, 81379 München (DE)
(74) Vertreter: Bardehle Pagenberg Partnerschaft mbB Patentanwälte Rechtsanwälte
(86) Internationale Anmeldenummer: PCT/EP2015/074148
(87) Internationale Veröffentlichungsnummer: WO 2016/091438

(56) Entgegenhaltungen:
- WO-A1-03/058810
- DE-A1-102012 112 058

## Beschreibung

Die Erfindung betrifft einfach herstellbare elektrische Bauelemente sowie einfache Verfahren zur Herstellung solcher Bauelemente.

Elektrische Bauelemente, z. B. elektrische oder elektronische Module oder sogenannte Bauelement-Packages oder Modul-Packages, umfassen im Allgemeinen einen oder mehrere Chips sowie ein oder mehrere mechanisch ausreichend stabile Trägersubstrate und Leiterbahnen für elektrische Verschaltungen zwischen Chips bzw. Chip und Trägersubstrat. Einige elektrische Bauelemente weisen dabei Chips auf, die mechanische oder elektromechanische Funktionen erfüllen sollen. Während Chips, die ausschließlich auf Halbleitertechnologie basierende integrierte Schaltungen umfassen, noch relativ unempfindlich gegenüber äußeren Einflüssen sind, ist das Integrieren eines mechanisch aktiven Chips aufgrund empfindlicher Bauelementstrukturen problematisch.

Aus den Veröffentlichungen US 8,227,904 B2, US 2009/0101998 A1 oder DE 102010006132 A1 sind elektrische Bauelemente mit miteinander verschalteten Chips bekannt. Die Herstellung solcher Bauelemente ist aufwendig, was sich in hohen Herstellungskosten und nicht optimaler Haltbarkeit widerspiegelt.

Das Dokument WO 03/058810 A1 bezieht sich auf ein Verfahren zur einfacheren und sichereren Verkapselung von elektronischen Bauelementen, wobei die Verbindung zwischen einem Chip und einem Trägersubstrat mittels Bumpverbindungen erzeugt wird, die in Ausnehmungen auf dem Trägersubstrat versenkt sind. Das Bauelement liegt dabei direkt auf dem Trägersubstrat auf, insbesondere auf einem die Bauelementstrukturen auf dem Chip umgrenzenden Rahmen.

Das Dokument DE 102012112058 A1 bezieht sich auf ein MEMS-Bauelement, welches auf einem Substrat Bauelementstrukturen, mit den Bauelementstrukturen verbundene Kontaktflächen, metallische Säulenstrukturen, die auf den Kontaktflächen aufsitzen und metallische Rahmenstrukturen, die die Bauelementstrukturen umgeben, aufweist. Eine gehärtete Resistschicht sitzt so auf Rahmenstruktur und Säulenstrukturen auf, dass ein Hohlraum zwischen Substrat, Rahmenstruktur und Resistschicht eingeschlossen ist. Direkt auf der Resistschicht oder auf einer auf der Resistschicht aufsitzenden Trägerschicht ist eine strukturierte Metallisierung vorgesehen, die zumindest Außenkontakte des Bauelements umfasst und sowohl mit metallischen Strukturen als auch den Kontaktflächen der Bauelementstrukturen elektrisch leitend verbunden ist.

Es besteht deshalb die Aufgabe, elektrische Bauelemente anzugeben, die mehrere Chips - insbesondere mechanisch aktive Chips - und elektrische Verschaltungen dazwischen umfassen können, den Chips eine geeignete und schützende Umgebung bie-ten, mit einfachen Mitteln herstellbar sind und eine lange Lebensdauer bieten. Entsprechend soll auch ein einfaches Verfahren zur Herstellung solcher Bauelemente angegeben werden.

Diese Aufgaben werden durch das Bauelement bzw. das Verfahren gemäß den unabhängigen Ansprüchen gelöst. Abhängige Ansprüche geben vorteilhafte Ausgestaltungen des Bauelements bzw. des Verfahrens an.

Das elektrische Bauelement umfasst ein Trägersubstrat mit zumindest einer Polymerlage. Das Bauelement umfasst ferner einen ersten Chip mit einer Verbindungsstruktur und einer metallischen Verschaltungsstruktur. Sowohl die Verbindungsstruktur als auch die metallische Verschaltungsstruktur sind an der Unterseite des Chips angeordnet. Der erste Chip ist auf dem Trägersubstrat angeordnet. Die Verbindungsstruktur liegt entweder auf der Polymerlage auf oder ragt in die Polymerlage, ohne sie vollständig zu durchdringen. Die Verschaltungsstruktur durchdringt die Polymerlage.

Es wird also ein elektrisches Bauelement angegeben, das unterschiedliche Strukturen an der Unterseite des Chips aufweist. Die Verbindungsstruktur weist im Allgemeinen eine niedrigere Höhe, gemessen ab der Unterseite des Chips, auf als die Verschaltungsstruktur. So kann die Verschaltungsstruktur die Polymerlage des Trägersubstrats unter dem Chip durchdringen und für elektrische Verschaltungen verwendet werden, während die Verbindungsstruktur eine mechanische Verbindung zwischen Chip und Trägersubstrat herstellt.

Da die Polymerlage als Teil des Trägersubstrats während der Herstellung relativ weich oder gar flüssig sein kann, können elektrische Durchkontaktierungen durch diese Lage des Trägersubstrats erhalten werden, indem der Chip mit seinen Strukturen an seiner Unterseite lediglich hinreichend stark auf das Trägersubstrat mit der weichen Polymerlage als oberste Lage gedrückt wird und die Polymerlage anschließend gehärtet wird. Sollte anschließend eine sich unter der Polymerlage befindliche weitere Lage des Trägersubstrats entfernt werden, so wären bereits elektrische Anschlüsse zum Chip an der Unterseite des Trägersubstrats vorhanden.

Je nach Topologie der Verbindungsstruktur kann ferner auf einfache Weise ein geschlossener Hohlraum in einem Spalt zwischen dem ersten Chip und dem Trägersubstrat erhalten werden, z. B. wenn die Verbindungsstruktur eine ringsum geschlossene Rahmenstruktur ausbildet.

Es ist dabei möglich, dass der erste Chip ein MEMS-Chip (MEMS = Micro-Electro-Mechanical System), ein NEMS-Chip (NEMS = Nano-Electro-Mechanical System), ein IC-Chip, ein optoelektronischer Chip, ein Aktuator-Chip oder ein lediglich passive Schaltungselemente umfassender Chip ist. Darüber hinaus kann der erste Chip auch ein kombinierter Chip sein, der Schaltungsstrukturen oder Bauelemente aus verschiedenen der oben genannten Chipkategorien aufweist.

Durch Einfachheit von Bauelemente mit durch Substratlagen reichende Kontaktierungen sind Fehlermöglichkeiten bei der Herstellung verringert, weshalb die Lebensdauer der Bauelemente erhöht ist.

Das Bauelement ist dabei nicht darauf beschränkt, nur einen oder wenige Chips zu umfassen. Vielmehr kann das Bauelement einen zweiten Chip bzw. eine Vielzahl weiterer Chips, die z. B. empfindliche, schutzbedürftige Chips der oben genannten Kategorien sein können, aufweisen.

Es ist ferner möglich, dass das Trägersubstrat neben der oben erwähnten Polymerlage eine Schicht umfasst, die unterhalb der Polymerlage angeordnet ist. Die Schicht kann dabei aus einer oder mehreren Lagen bestehen und ein SESUB (Semi-conductor Embedding Substrate), eine Leiterplatte, ein LTCC-Substrat (LTCC = Low-Temperature Co-fired Ceramics), ein HTCC-Substrat (HTCC = High-Temperature Co-fired Ceramics), eine organische Trägerfolie, eine anorganische Trägerfolie, eine Metallfolie, ein einkristallines Substrat, ein polykristallines Substrat, ein halbleitendes Substrat, ein Keramiksubstrat oder ein Glassubstrat sein. Auch eine Schichtenkombination dieser prinzipiell als Trägermaterial geeigneten Materialien kann unterhalb der Polymerlage - zumindest während der Herstellung des Bauelements - angeordnet sein.

Es wird ferner angegeben, dass das Bauelement einen Spalt zwischen dem ersten Chip und dem Trägersubstrat aufweist. Empfindliche Strukturen, z. B. MEMS-Bauelementstrukturen, sind an der Unterseite des ersten Chips angeordnet, ohne das Trägersubstrat zu berühren. Dabei gibt die Bauhöhe der Verbindungsstruktur im Wesentlichen den Abstand zwischen der Unterseite des ersten Chips und der Oberseite der Polymerlage an, wenn die Verbindungsstruktur - vorzugsweise plan - auf der Polymerlage aufliegt. Da die Verbindungsstruktur insbesondere dazu verwendet werden kann, einen Hohlraum zwischen Chip und Trägersubstrat auszubilden und da ein hermetisch dichter Hohlraum in vielen Anwendungsfällen bevorzugt ist, kann die Verbindungsstruktur etwas in die Polymerlage hineinragen, um einen dichten Abschluss auch bei einer gewissen Welligkeit der Polymerlage sicherzustellen. Somit bestimmt die Welligkeit der Polymerlage den kleinstmöglichen gleichmäßigen Abstand zwischen Chip und Trägersubstrat. Dieser Abstand kann beispielsweise 5 µm betragen. Die Polymerlage kann dabei zwischen 10 µm und 50 µm dick sein. Entsprechend ergibt sich eine Bauhöhe der Verbindungsstruktur zu 5 µm oder einige Prozent mehr als 5 µm. Die Bauhöhe der Verschaltungsstruktur ergibt sich als Abstand zwischen Chip und Trägersubstrat plus Dicke der Polymerlage (im Wesentlichen).

Die (empfindlichen) Bauelementstrukturen an der Unterseite des ersten Chips können beispielsweise SAW-Strukturen (SAW = Surface Acoustic Wave = akustische Oberflächenwelle), BAW-Strukturen (BAW = Bulk Acoustic Wave = akustische Volumenwelle) oder elektro-akustische Wandlerstrukturen von Mikrofonchips sein. Solche Strukturen benötigen im Allgemeinen einen gewissen Abstand zu benachbarten Oberflächen, um frei schwingen zu können.

Es ist deshalb ferner möglich, dass der Spalt zwischen dem ersten Chip und dem Trägersubstrat seitlich durch die an der Unterseite des Chips als Rahmen ausgebildete Verbindungsstruktur begrenzt ist. Dieser Rahmen, der Chip und das Trägersubstrat umschließen somit einen Hohlraum. Der Rahmen kann eine rechteckige Form aufweisen. Andere Formen, z. B. Polygone mit drei, fünf, sechs, sieben, acht oder mehr Ecken, die über gerade Verbindungselemente des Rahmens verbunden sind oder Rahmen mit gebogenen Segmenten sind ebenfalls möglich.

Neben dem Rahmen kann die Verbindungsstruktur noch weitere Elemente aufweisen, die beispielsweise als Abstandshalter innerhalb des Rahmens oder außerhalb des Rahmens angeordnet sind und einen gleichmäßigen Abstand zwischen Chip und Trägersubstrat sicherstellen, selbst wenn auf den Chip eine Kraft ausgeübt wird. Solche Abstandshalter können insbesondere sogenannte Pillars sein.

Es ist möglich, dass die Verbindungsstruktur an der Unterseite des ersten Chips als Hauptbestandteil ein Polymer, Cu (Kupfer), Al (Aluminium), Ag (Silber) oder Au (Gold) oder weitere Metalle aufweist. Die Verschaltungsstruktur kann ebenfalls beispielsweise Cu, Al, Ag oder Au als ein metallischer Hauptbestandteil oder ein Polymer mit elektrisch leitenden, metallischen Nanopartikeln aus diesen Metallen aufweisen.

Unter den Metallen als Hauptbestandteil ist insbesondere Cu sowohl für die Verbindungsstruktur als auch für die Verschaltungsstruktur bevorzugt, da Cu kompatibel mit Standard-CMOS-Prozessen ist, eine gute elektrische Leitfähigkeit aufweist, gute mechanische Steifigkeitswerte hat und einer oxidierenden Atmosphäre während eines Herstellungsprozesses ausreichend lange standhält.

Unter den nicht metallischen Hauptbestandteilen hat ein Polymer den Vorteil, dass es mittels Jetten mit einem Polymer-Drucker mit einer guten lateralen Auflösung präzise positioniert und in ausreichender Dicke hergestellt werden kann. Umfasst das zu jettende Polymermaterial Metall, z. B. in Form metallischer Nanopartikel, so können sogar elektrisch leitende Strukturen mit einem dreidimensionalen Profil gedruckt werden.

Es ist möglich, dass die Verschaltungsstruktur eine oder mehrere Bump-Verbindungen oder metallische Pillars zwischen Chip und Trägersubstrat oder eine Durchkontaktierung durch den Chip und/oder das Trägersubstrat umfasst.

Es ist ferner möglich, dass die Verbindungsstruktur Stützen mit rundem oder rechteckigem Querschnitt (Pillars) oder stützende Rahmen umfasst.

Insbesondere wenn der Chip auf dem Trägersubstrat während eines Herstellungsprozesses von einer Mold-Masse umgeben wird, können hohe Drücke auf den Chip einwirken. Durch das Vorsehen von Stützelementen als Teilen der Verbindungsstruktur zwischen Chip und Trägersubstrat können die Position des Chips und insbesondere die möglicherweise empfindlicheren elektrischen Verschaltungsstrukturen stabilisiert werden.

Stützende Verbindungsstrukturen zwischen Chip und Trägersubstrat können ferner negative Auswirkungen durch unterschiedliche Ausdehnungskoeffizienten der Materialien zwischen Chip und Trägersubstrat verringern oder gar kompensieren.

Es wird ferner angegeben, dass das Bauelement einen zweiten Chip umfasst. Der zweite Chip kann über oder direkt auf dem ersten Chip angeordnet sein. Der zweite Chip wird neben dem ersten Chip auf dem Trägersubstrat angeordnet.

Ein solches Bauelement umfasst somit zwei Chips. Einer der beiden Chips kann mechanisch aktive Bauelementstrukturen umfassen, während der jeweils andere Chip integrierte Schaltungen beinhaltet, in denen beispielsweise ein ASIC (ASIC = Application-Specific Integrated Circuit = anwendungsspezifische integrierte Schaltung) realisiert ist. So kann der mechanische Bauelementstrukturen tragende Chip beispielsweise ein Mikrofonchip mit einer frei schwingenden elektrisch leitenden Membran und einer elektrisch leitenden Rückplatte sein, während der andere Chip eine analoge oder digitale Auswert-Logik umfasst, um elektrisch codierte Ausgangssignale eines empfangenen akustischen Signals auszugeben.

Es ist möglich, dass das Bauelement ferner eine Verkapselung mit einem Laminat, einer Mold-Masse, einer per Druckverfahren aufgebrachten Masse oder einer Folie oberhalb des ersten Chips und/oder ein Füllmaterial, das direkt auf einem Bereich des Trägersubstrats angeordnet ist, umfasst. Das Füllmaterial (z. B. ein sogenannter Underfiller) kann dabei einen Spalt zwischen einem Chipmaterial, z. B. des ersten oder eines weiteren Chips, und dem Trägersubstrat füllen, um eine stabile Verbindung zwischen Chip und Trägersubstrat herzustellen oder einen Hohlraum unter einem Chip abzudichten.

Es ist ferner möglich, dass das Bauelement eine Deckschicht aus Metall über dem ersten Chip oder über weiteren Chips umfasst. Die Deckschicht aus Metall kann dabei in direktem Kontakt mit dem Chip sein. Es ist auch möglich, dass das Metall der Deckschicht eine der obersten Lagen des Bauelements ist und alle darunter liegenden Lagen elektromagnetisch abschirmt.

Haben nebeneinander angeordnete Chips einen Abstand, der z. B. größer als 200 µm sein kann, so ist es möglich, eine bedeckende Folie bis zur Oberfläche des Substrats herunterzuziehen.

Haben nebeneinander angeordnete Chips einen Abstand, der z. B. kleiner als 50 µm ist, so kann die Folie einen Teil einer einschließenden Umgebung eines Hohlraumes darstellen, wenn sie nicht bis zum Substrat herunter gezogen wird.

Umfasst die Deckschicht eine oder mehrere Lagen mit einem hohen akustischen Kontrast, so kann durch selektives Abtragen eine Beschriftung des Bauelements erhalten werden.

Es ist möglich, dass der erste Chip oder ein weiterer Chip ein Sensorchip ist. Der Chip kann unter einer Abdeckung angeordnet sein. Damit der Sensorchip mit der Umgebung des Bauelements kommunizieren kann und beispielsweise Druckverhältnisse oder verschiedene Gaszusammensetzungen analysieren kann, ist er über ein Loch in der Abdeckung mit der Umgebung verbunden.

Es ist möglich, dass das Bauelement ein Mikrofon ist. Der Sensorchip umfasst dann elektroakustische Wandlerstrukturen, z. B. eine Membran und eine Rückplatte. Unter der Abdeckung ist ein Rückvolumen gebildet.

Die Signalqualität, die ein Mikrofon zur Verfügung stellen kann, hängt unter anderem vom sogenannten Rückvolumen ab. Das Rückvolumen ist das Volumen des Raums, der in akustischer Richtung hinter der Membran gelegen ist. Je kleiner das Rückvolumen ist, desto höher ist der Gegendruck, der gegen eine Auslenkung der Membran in Richtung der Schallausbreitung arbeitet. Deshalb werden große Rückvolumina bevorzugt. Da allerdings der anhaltende Trend zur Miniaturisierung großen Rückvolumina entgegengerichtet ist, ist es stets bevorzugt, Mikrofone mit großen Rückvolumina, aber insgesamt kleinen Abmessungen anzugeben. Umfasst das elektrische Bauelement neben dem ersten Chip weitere Schaltungselemente, so können diese unter einer gemeinsamen Abdeckung angeordnet sein und der Raum zwischen den Chips unter der Abdeckung als vergrößertes Rückvolumen genutzt werden.

Auch das Vorsehen von Ausnehmungen im Trägersubstrat kann zur Vergrößerung eines Rückvolumens dienen.

Es ist möglich, dass das Bauelement neben dem ersten Chip noch zumindest einen weiteren Chip umfasst. Der weitere Chip ist ebenfalls an der Oberseite des Trägersubstrats angeordnet. Die auf der Oberseite des Trägersubstrats verlaufende Verbindungsstrecke zwischen den Chips ist so lang, dass das Trägersubstrat an einer Knicklinie, die zwischen den Chips verläuft, gebogen werden kann, ohne dass sich die Chips gegenseitig berühren oder anderweitig stören. Werden mehrere solcher Knicklinien vorgesehen, kann ein Bauelement mit primär großer Oberfläche zu einem kompakten Bauelement zusammengefaltet werden. Das gefaltete Bauelement kann später mit einer Vergussmasse vergossen werden, sodass ein mechanisch stabiles vergossenes Bauelement mit präzise definierten Abständen zwischen verschiedenen Schaltungskomponenten erhalten wird.

Es ist ferner möglich, dass das Bauelement auf der Oberseite des Trägersubstrats freiliegende Leiterbahnen und/oder Kontaktflächen aufweist, die dazu vorgesehen sind, über eine Steckverbindung mit einer externen Schaltungsumgebung verbunden und verschaltet zu werden. Bevorzugt enden die Leiterbahnen an Kanten des Trägersubstrats. Dort sind die Leiterbahnen bevorzugt zu Kontaktpads verbreitert. Damit bildet das Bauelement einen Stecker, der leicht in eine entsprechend angepasste Fassung gesteckt werden kann. Eine solche Steckverbindung hat den Vorteil, dass sie gleichzeitig eine elektrische Verschaltung und eine mechanische Verbindung darstellt und einfach zu lösen ist. Ein Austausch eines defekten Bauelements kann somit leicht durchgeführt werden.

Ein Verfahren zur Herstellung eines elektrischen Bauelements umfasst das Bereitstellen eines ersten Chips. An der Unterseite des ersten Chips werden eine metallische Verbindungsstruktur und eine metallische Verschaltungsstruktur ausgebildet. Die Verbindungsstruktur und die Verschaltungsstruktur weisen beide unterschiedliche Höhen auf.

Ferner wird ein Trägersubstrat mit einer ausreichend weichen Polymerlage bereitgestellt.

Der erste Chip und das Trägersubstrat werden verbunden. Dabei durchdringt die Verschaltungsstruktur die dazu hinreichend weiche Polymerlage. Die Verschaltungsstruktur berührt die Polymerlage oder dringt geringfügig in sie ein, ohne sie vollständig zu durchdringen.

Es ist möglich und - je nach Viskosität der Polymerlage - nötig, die Polymerlage nach dem Aufsetzen des ersten Chips auf die einen wesentlichen Bestandteil eines Trägersubstrats bildende Polymerlage zu härten. Die Polymerlage kann dabei durch Beleuchten oder durch Erhitzen gehärtet werden.

Wird die Polymerlage durch Erhitzen gehärtet, so wirkt sich die Existenz der Verbindungsstruktur unterhalb des ersten Chips vorteilhaft aus, da unterschiedliche thermische Ausdehnungskoeffizienten vorhanden sein können.

Es ist möglich, dass das Trägersubstrat unter der Polymerlage eine Schicht umfasst, die in einem geeigneten optischen Wellenlängenbereich transparent ist. Das Härten der Polymerschicht erfolgt dann bevorzugt durch Belichten mittels Lichts dieses Wellenlängenbereichs. Geeignet ist dabei derjenige optische Wellenlängenbereich, in dem das Härten der Polymerschicht gut möglich ist. Insbesondere durch UV-Strahlung kann ein Härten der Polymerschicht leicht erfolgen.

Neben oder auf dem ersten Chip können noch ein weiterer Chip oder eine Vielzahl weiterer Chips angeordnet werden.

Es ist möglich, dass ein Füllmaterial, z. B. ein Underfiller, in Bereichen zwischen einem Chipmaterial und dem Trägersubstrat angeordnet wird.

Dadurch, dass die Verbindungsstrukturen einen Rahmen um einen Hohlraum ausbilden können, kann ein Füllmaterial ohne Gefahr der Flutung des Hohlraums großflächig auf die Oberseite des Trägersubstrats aufgebracht werden.

Es ist möglich, dass eine Mold-Masse und/oder eine Folie über dem ersten Chip aufgebracht wird.

Es ist ferner möglich, dass eine metallische Deckschicht auf den ersten Chip oder über dem ersten Chip aufgebracht wird.

Es ist möglich, dass das Trägersubstrat unter der Polymerlage eine weitere Schicht umfasst und die weitere Schicht nach dem Härten der Polymerlage vollständig oder selektiv in Bereichen der Verschaltungsstruktur entfernt und dabei die Verschaltungsstruktur freigelegt wird.

Das Freilegen der Verschaltungsstruktur kann dabei mittels Laser erfolgen.

Die Verschaltungsstruktur kann Kontakte umfassen. Die Kontakte der Verschaltungsstruktur werden nach dem Freilegen durch Ausbilden von Leiterstrukturen an der Unterseite des Trägersubstrats kontaktiert.

Zum Ausbilden der Leiterstrukturen können übliche Lithografie-Prozesse Verwendung finden.

Es ist möglich, dass eine Vielzahl Bauelemente gleichzeitig in Mehrfachnutzen hergestellt wird. Nachdem alle Komponenten für alle Bauelemente zusammengefügt sind, können die einzelnen Bauelemente durch Vereinzeln getrennt werden.

Es ist möglich, dass auf der Oberseite des Bauelements Schichtkombinationen mit hohem optischen Kontrast abgeschieden werden. Solche Schichtkombinationen können beispielsweise Schichten oder Lagen mit Kupfer, Nickel und Schwarznickel umfassen. Anschließend wird das Bauelement durch selektives Abtragen des Nickel umfassenden Materials beschriftet.

Es ist möglich, dass elektrisch leitende Strukturen an der Oberfläche des Chips und/oder an der Oberfläche des Trägersubstrats durch Abscheiden eines Metalls oder einer Legierung oder durch Jetten von Metall umfassenden Partikeln, z. B. Nanopartikeln, gebildet werden. Elektrisch leitende Strukturen können so durch galvanische oder stromlose Prozesse oder durch Drucken mit einem geeigneten Drucker erzeugt werden.

Chips können übereinander gestapelt und über Durchkontaktierungen miteinander oder mit dem Substrat verschaltet sein. Dazu können auf einer Chipoberfläche auch Umverdrahtungslagen angeordnet sein, über die Kontakte in verschiedener lateraler Position verschaltet sind.

Elektrische Lotverbindungen, z. B. zwischen Chips und Substrat oder zwischen Chips untereinander, können z. B. mittels Bügellöten erstellt werden.

Nachfolgend werden wesentliche Merkmale des Bauelements bzw. des Verfahrens anhand von schematischen, nicht einschränkenden Figuren näher erläutert.

Es zeigen:
- Fig. 1:: eine als Basis für die Polymerlage dienende untere Trägersubstratlage TSU,
- Fig. 2:: ein Trägersubstrat mit einer oberen Trägersubstratlage TSO,
- Fig. 3:: einen ersten Chip CH1 mit Bauelementstrukturen BES an seiner Unterseite,
- Fig. 4:: den ersten Chip, an dessen Unterseite inzwischen eine Verschaltungsstruktur VSS ausgebildet ist,
- Fig. 5:: eine Version des Chips, an dessen Unterseite ferner eine Verbindungsstruktur VBS angeordnet ist,
- Fig. 6:: die Anordnung des ersten Chips CH1 auf dem Trägersubstrat TS,
- Fig. 7:: die Anordnung eines zweiten Chips CH2 auf dem Trägersubstrat TS,
- Fig. 8:: ein Abschnitt des Trägersubstrats, auf dem der erste Chip CH1 und der zweite Chip CH2 nebeneinander angeordnet sind,
- Fig. 9:: ein Füllmaterial UF in einem Spalt zwischen dem zweiten Chip CH2 und dem Trägersubstrat,
- Fig. 10:: ein Trägersubstrat, in dessen untere Lage TSU Löcher L strukturiert sind,
- Fig. 11:: Metallisierungen M an der Unterseite des Trägersubstrats, die Kontaktpads KP und Signalpfade zwischen verschiedenen elektrischen Kontakten der Chips realisieren,
- Fig. 12:: eine Ausgestaltung des Trägersubstrats, das nach dem Aushärten der Polymerlage außer der Polymerlage keine weiteren Schichten mehr umfasst,
- Fig. 13:: die direkte Anordnung des zweiten Chips CH2 auf der Polymerlage ohne weiteres Füllmaterial,
- Fig. 14:: ein Trägersubstrat, das nicht durch ein Füllmaterial unter dem zweiten Chip verstärkt ist,
- Fig. 15:: eine Folie F, die über den Chips an der Oberseite des Trägersubstrats angeordnet ist,
- Fig. 16:: eine Draufsicht auf ein Bauelement, die die Wirkung der rahmenförmigen Verbindungsstruktur als Barriere gegen ein Füllmaterial illustriert,
- Fig. 17:: ein Bauelement mit Signalleitungen und Kontaktpads auf der Oberseite des Trägersubstrats zur Ausbildung einer Steckverbindung,
- Fig. 18:: ein Bauelement mit einer Vergussmasse VM,
- Fig. 19:: ein als Mikrofon ausgestaltetes Bauelement mit einem Rückvolumen unter einem Deckel,
- Fig. 20:: ein als Mikrofon ausgestaltetes Bauelement mit einem Rückvolumen in einer Ausnehmung unterhalb des ersten Chips,
- Fig. 21:: eine Ausgestaltung des Bauelements als Mikrofon, bei dem ein großer Teil des Rückvolumens in einer Ausnehmung neben dem elektroakustischen Wandlerchip angeordnet ist.

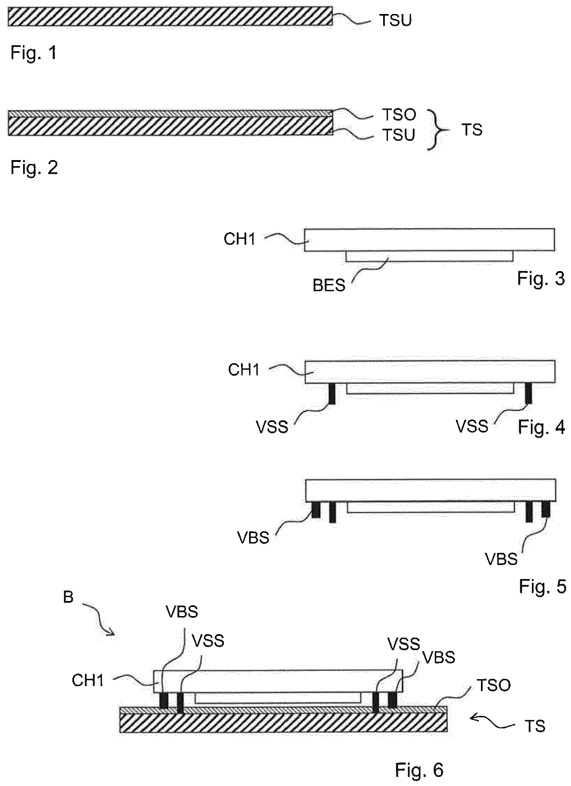

Figur 6 zeigt die wesentlichen geometrischen Abmessungen bzw. Strukturhöhen der Verbindungsstruktur VBS und der Verschaltungsstruktur VSS relativ zur Dicke der ein Polymer umfassenden oberen Lage des Trägersubstrats TSO. Die Verbindungsstruktur VBS und die Verschaltungsstruktur VSS sind an der Unterseite des ersten Chips CH1 angeordnet. Die Höhe der Verschaltungsstruktur VSS übersteigt die Höhe der Verbindungsstruktur VBS. Die Verbindungsstruktur VBS dient im Wesentlichen dazu, einen Abstand zwischen der Unterseite des ersten Chips CH1 und der Oberseite des Trägersubstrats TS einzuhalten. Dabei berührt die Verbindungsstruktur VBS die oberste Lage TSO des Trägersubstrats TS, die im Wesentlichen aus einem Polymermaterial besteht. Es ist möglich, dass die Verbindungsstruktur VBS im Wesentlichen auf der Oberseite der oberen Lage TSO sitzt oder gegebenenfalls geringfügig in die obere Lage TSO eingedrückt ist.

Die Verschaltungsstruktur VSS dringt aufgrund ihrer größeren Höhe durch die Polymer umfassende obere Lage TSO des Trägersubstrats TS. Soll später ein elektrischer Kontakt zu Elementen der Verschaltungsstruktur VSS erfolgen, so ist lediglich die untere Lage des Trägersubstrats TSU zu durchdringen. Dabei kann die obere Lage TSO im Wesentlichen bestehen bleiben und eine mechanische Stabilität sicherstellen.

Die Figuren 1 bis 5 stellen wesentliche Schritte zur Herstellung eines solchen Bauelements dar:
In Figur 1 ist die Grundlage des Trägersubstrats, nämlich eine untere Lage TSU des Trägersubstrats, gezeigt.

Darauf wird eine Polymer umfassende obere Lage TSO aufgebracht (Figur 2). Die obere Lage ist dabei so weich, dass die Verschaltungsstruktur VSS diese später leicht durchdringen kann. Es ist insbesondere möglich, dass die obere Lage TSO flüssig ist.

Figur 3 zeigt einen ersten Chip CH1, der an seiner Unterseite empfindliche Bauelementstrukturen BES, z. B. SAW-Strukturen, BAW-Strukturen oder Membranen oder Rückplatten, trägt. Die Bauelementstrukturen zeichnen sich dadurch aus, dass sie frei schwingend an der Unterseite des ersten Chips CH1 angeordnet sein sollten, um eine einwandfreie Funktion zu gewährleisten.

Figur 4 zeigt, wie eine Verschaltungsstruktur VSS an der Unterseite des ersten Chips CH1 angeordnet sein kann, um beispielsweise die Bauelementstrukturen mit einer externen Schaltungsumgebung oder mit weiteren Schaltungskomponenten des Bauelements zu verschalten.

Figur 5 zeigt zusätzlich die Verbindungsstruktur VBS an der Unterseite des ersten Chips. Damit ein ausreichender Abstand zwischen den Bauelementstrukturen BES und dem dafür vorgesehenen Trägersubstrat TS eingehalten werden kann, hat die Verbindungsstruktur VBS vorzugsweise eine größere Bauhöhe als die Bauelementstrukturen BES.

So wird nach dem Verbinden des ersten Chips CH1 mit seinen Strukturen an seiner Unterseite und dem Trägersubstrat TS das in Figur 6 gezeigte Bauelement erhalten, bei dem die Bauelementstrukturen einen ausreichenden Abstand vom Trägersubstrat TS aufweisen. Ist die Verbindungsstruktur VBS in sich geschlossen, so wird insbesondere ein abgeschlossener Hohlraum erhalten, in dem die Bauelementstrukturen angeordnet sind.

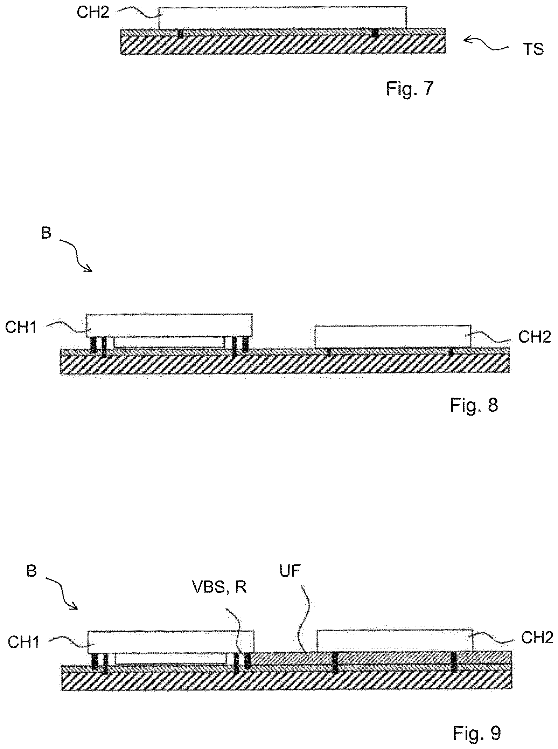

Figur 7 zeigt ferner einen Abschnitt des Trägersubstrats TS, auf dem ein zweiter Chip CH2 angeordnet ist. Der zweite Chip braucht keine empfindlichen Bauelementstrukturen an seiner Oberfläche aufweisen. Deshalb ist ein direkter Kontakt seiner Unterseite mit dem Trägersubstrat TS unschädlich. Verbindungsstrukturen zwischen dem zweiten Chip CH2 und dem Trägersubstrat TS sind möglich, aber nicht notwendig.

Figur 8 zeigt nun ein Bauelement B, bei dem ein erster Chip CH1 mit mechanisch empfindlichen Bauelementstrukturen an seiner Unterseite zusammen mit einem weniger empfindlichen zweiten Chip CH2 auf dem Trägersubstrat angeordnet sind. Beide Chips umfassen elektrische Kontaktstrukturen an ihren Unterseiten, die durch die oberste, Polymer umfassende Lage des Trägersubstrats TS führen.

Figur 9 zeigt eine Ausführungsform, bei der der zweite Chip CH2 nicht in direktem Kontakt mit dem Trägersubstrat ist. Sollte ein Freiraum zwischen dem zweiten Chip CH2 und dem Trägersubstrat TS unerwünscht sein, so kann das Volumen unter dem zweiten Chip CH2 durch ein Füllmaterial, z. B. einen Unterfiller UF, gefüllt werden.

Da die Verbindungsstruktur VBS des ersten Chips CH1 als ringförmig geschlossener Rahmen R ausgestaltet sein kann, sind auch die empfindlichen Bauelementstrukturen an der Unterseite des ersten Chips CH1 nicht durch das Aufbringen des Underfillers UF gefährdet. Vielmehr kann das Füllmaterial UF eine hermetische Abdichtung des Hohlraums unter dem ersten Chip CH1 verbessern.

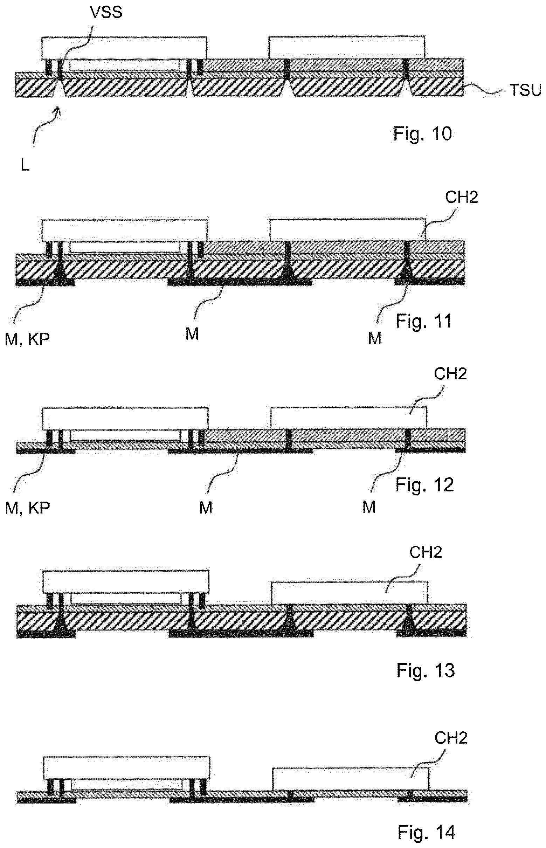

Figur 10 zeigt einen wesentlichen Vorteil der vorliegenden Konstruktion gegenüber konventionellen Bauelementen für den Fall, dass die Verschaltungsstrukturen VSS elektrisch kontaktiert werden sollen. Vorzugsweise ist die obere Lage des Trägersubstrats inzwischen gehärtet und kann eine ausreichende mechanische Stabilität bereitstellen. Dann ist es lediglich nötig, die darunter befindlichen Schichten TSU zu durchdringen und dadurch die Verschaltungsstrukturen VSS freizulegen, um durch Ausbilden von Signalleitungen eine Verschaltung der Verschaltungsstrukturen vorzunehmen. So können beispielsweise mittels Laser Löcher L in die unter der Polymerlage angeordnete Schicht TSU des Trägersubstrats TS gebohrt werden.

Figur 11 zeigt diejenigen Metallisierungen M, die über übliche Lithografieprozesse an der Unterseite des Trägersubstrats angeordnet sind und elektrische Kontakte der Chips untereinander oder Kontakte der Chips und externe Kontaktpads KP verschalten.

Figur 12 zeigt eine Ausführungsform, bei der nicht einzelne Löcher L selektiv an den Plätzen der Verschaltungsstruktur VSS gebohrt sind, sondern die untere Lage TSU des Trägersubstrats TS vollständig entfernt ist, bevor die Metallisierung M zur Bildung von Signalpfaden auf der Unterseite aufgebracht wurde.

Die Figuren 13 und 14 zeigen die entsprechenden elektrischen Verbindungen an der Unterseite des Trägersubstrats, wobei zwischen dem Trägersubstrat und dem zweiten Chip CH2 kein Füllmaterial angeordnet ist. Je nach Dicke und Stabilität der Polymerlage stellt diese bereits eine ausreichende mechanische Stabilität (Figur 14) zur Verfügung.

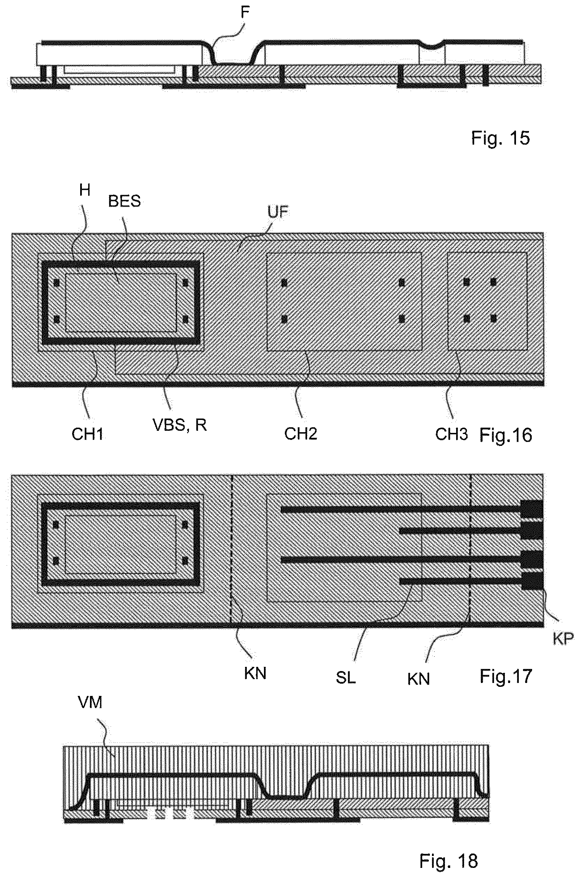

Figur 15 zeigt die weitere Möglichkeit, die Oberseite des Bauelements durch eine Folie F abzudecken. Je nachdem, wie weit die Chips an der Oberseite des Trägersubstrats voneinander entfernt sind, ist es möglich, die Folie F mit der Oberseite des Trägersubstrats zu verbinden oder einen Hohlraum zwischen den Chips unter der Folie einzuschließen. Berührt die Folie die Oberseite des Trägersubstrats, so kann die Folie mit einem elektrischen Potenzial verschaltet werden, z. B. über Durchkontaktierungen durch das Trägersubstrat. Ferner ist es möglich, ein entsprechend im Mehrfachnutzen hergestelltes Trägersubstrat zu vereinzeln, um eine Vielzahl unterschiedlicher Bauelemente zu erhalten, wobei das Abdichten der Folie durch das Vereinzeln nicht unterlaufen wird.

Bildet die Folie zusammen mit dem Trägersubstrat und den Seitenflächen der Chips Hohlräume aus, so können die als Rückvolumina für Mikrofone gebildet werden.

Figur 16 zeigt die Schutzwirkung einer als Rahmen ausgebildeten Verbindungsstruktur VBS, die ein Fluten des Hohlraums H unter dem ersten Chip CH1 durch Füllmaterial UF wirksam verhindert. Die Bauelementstrukturen BES sind somit sicher im Hohlraum H untergebracht.

Neben dem ersten Chip CH1 sind ein weiterer Chip CH2 und ein dritter Chip CH3 auf der Oberseite des Trägersubstrats angeordnet.

Figur 17 zeigt die Möglichkeit, Signalleitungen SL durch Metallisierungen auf der Oberfläche des Trägersubstrats auszubilden. Die Signalleitungen können dabei von Kontakten eines der Chips zu einer Kante des Bauelements verlaufen und in einem Kontaktpad KP enden. Damit wird auf einfache Weise eine Steckverbindung zu einer externen Schaltungsumgebung ermöglicht.

Knicklinien KN können so gewählt sein, dass Chips oder andere Schaltungskomponenten auf der Oberseite des Trägersubstrats nach einem Umbiegen des Trägersubstrats an der Knickkante KN noch ausreichend Platz haben. Nach dem Umbiegen kann das Trägersubstrat mit seinen Bauelementen an der Oberfläche durch ein Gussmaterial, z. B. ein Polymer oder ein Kunstharz, vergossen werden.

Eine solche Vergussmasse ist in Figur 18 gezeigt. Dabei bedeckt die Vergussmasse die gesamte Oberseite des Bauelements.

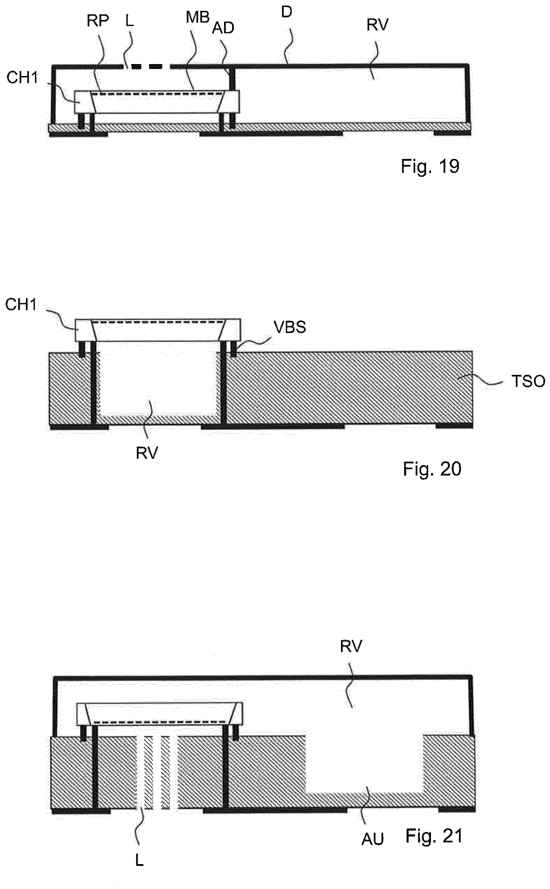

Figur 19 zeigt eine Ausführungsform des Bauelements als Mikrofon. Der erste Chip CH1 trägt eine Membran MB und eine Rückplatte RP als Bauelementstrukturen. Die Oberseite des Trägersubstrats ist durch einen Deckel D abgedeckt. Im Deckel D sind Löcher als Schalleintrittsöffnungen strukturiert. Der Deckel D umfasst ferner ein Rückvolumen RV neben dem ersten Chip CH1. Damit ein akustischer Kurzschluss vermieden wird, ist eine akustische Dichtung AD zwischen dem Schalleintritt und dem Rückvolumen RV gebildet. Die Verbindungsstruktur ist in diesem Fall nicht vollständig geschlossen, sodass ein Gasaustausch zwischen dem Volumen hinter der Membran MB des ersten Chips CH1 und dem Rückvolumen RV möglich ist.

Figur 20 zeigt die Möglichkeit, das Rückvolumen hinter der Membran durch eine Ausnehmung im Trägersubstrat bzw. in dessen oberster Lage TSO vorzusehen.

Je dicker die oberste Lage des Trägersubstrats TSO, desto größer ist das Rückvolumen RV. Die Verschaltungsstrukturen sind dabei lang genug, um die oberste Lage TSO vollständig zu durchdringen.

Figur 21 zeigt eine weitere Ausführungsform des Bauelements als Mikrofon, bei der ein Teil des Rückvolumens durch eine Ausnehmung AU im Trägersubstrat neben dem ersten Chip gebildet ist. Weiter Löcher L durch das Trägersubstrat stellen eine Schalleintrittsöffnung dar. Die Verbindungsstrukturen sind in diesem Ausführungsbeispiel ringförmig geschlossen, um einen akustischen Kurzschluss zu vermeiden.

Weder das Bauelement noch das Verfahren zur Herstellung eines Bauelements sind auf die gezeigten oder beschriebenen Ausführungsformen beschränkt.

### Bezugszeichenliste

- AU:: Ausnehmung
- B:: Bauelement
- BES:: Bauelementstrukturen
- CH1:: erster Chip
- CH2:: zweiter Chip
- CH3:: dritter Chip
- D:: Deckel
- F:: Folie
- H:: Hohlraum
- KN:: Knicklinie
- KP:: Kontaktpad
- L:: Loch
- M:: Metallisierung
- MB:: Membran
- R:: Rahmen
- RP:: Rückplatte
- RV:: Rückvolumen
- SL:: Signalleiter
- TS:: Trägersubstrat
- TSO:: oberste Lage des Trägersubstrats
- TSU:: Lage unterhalb der obersten Lage des Trägersubstrats
- UF:: Füllmaterial bzw. Underfiller
- VBS:: Verbindungsstruktur
- VM:: Vergussmasse
- VSS:: Verschaltungsstruktur

## Patentansprüche

1. Elektrisches Bauelement (B), umfassend
- ein Trägersubstrat (TS) mit zumindest einer Polymerlage (TSO),
- einen ersten Chip (CH1) mit einer Verbindungsstruktur (VBS) an seiner Unterseite und mit einer metallischen Verschaltungsstruktur (VSS) an seiner Unterseite,
wobei
- der erste Chip (CH1) auf dem Trägersubstrat (TS) angeordnet ist,
- die Verbindungsstruktur (VBS) auf der Polymerlage (TSO) aufliegt oder in die Polymerlage (TSO) ragt, ohne sie zu durchdringen,
- die Verschaltungsstruktur (VSS) die Polymerlage (TSO) durchdringt,
- einen Spalt zwischen dem ersten Chip (CH1) und dem Trägersubstrat (TS), wobei empfindliche Strukturen (BES) an der Unterseite des ersten Chips (CH1) angeordnet sind, ohne das Trägersubstrat (TS) zu berühren, **gekennzeichnet durch**
- einen zweiten Chip (CH2), der neben dem ersten Chip (CH1) auf dem Trägersubstrat (TS) angeordnet ist und mit dem ersten Chip (CH1) elektrisch kontaktiert ist.

2. Bauelement nach dem vorherigen Anspruch, wobei der erste Chip (CH1) ausgewählt ist aus: einem MEMS-Chip, einem NEMS-Chip, einem IC-Chip, einem optoelektronischen Chip, einem Aktuator-Chip, einem nur passive Schaltungselemente umfassenden Chip.

3. Bauelement nach einem der vorherigen Ansprüche, wobei das Trägersubstrat (TS) ferner eine Schicht (TSU) umfasst, die ausgewählt ist aus: einem SESUB, einer Leiterplatte, einem LTCC Substrat, einem HTCC Substrat, einer organischen Trägerfolie, einer anorganischen Trägerfolie, einer Metallfolie, einem einkristallinen Substrat, einem polykristallinen Substrat, einem halbleitenden Substrat, einem Keramiksubstrat, einem Glassubstrat.

4. Bauelement nach dem vorherigen Anspruch, wobei der Spalt seitlich durch die an der Unterseite des Chips als Rahmen (R) ausgebildete Verbindungsstruktur (VBS) begrenzt ist und Chip (CH1), Rahmen (R) und Trägersubstrat (TS) einen Hohlraum (H) umschließen.

5. Bauelement nach einem der vorherigen Ansprüche, wobei
- die Verbindungsstruktur (VBS) als Hauptbestandteil ein Polymer, Cu, Al, Ag oder Au und
- die Verschaltungsstruktur (VSS) als Hauptbestandteil Cu, Al, Ag oder Au aufweist.

6. Bauelement nach einem der vorherigen Ansprüche, wobei die Verschaltungsstruktur (VSS)
- eine Bump-Verbindung, oder metallische Pillars oder
- eine Durchkontaktierung durch den Chip (CH1) und/oder das Trägersubstrat (TS) umfasst.

7. Bauelement nach einem der vorherigen Ansprüche, wobei die Verbindungsstruktur (VBS) Stützen mit rundem oder rechteckigem Querschnitt oder stützende Rahmen (R) umfasst.

8. Bauelement nach einem der vorherigen Ansprüche, ferner umfassend
- eine Verkapselung mit einem Laminat, einer Mold-Masse (VM), einer per Druckverfahren aufgebrachten Masse oder einer Folie (F) oberhalb des ersten Chips (CH1) und/oder
- ein Füllmaterial (UF), das direkt auf einem Bereich des Trägersubstrats (TS) angeordnet ist und einen Spalt zwischen einem Chipmaterial und dem Trägersubstrat (TS) füllt.

9. Bauelement nach einem der vorherigen Ansprüche, mit mindestens einem weiteren Chip (CH3), wobei der weitere Chip (CH3) an der Oberseite des Trägersubstrats (TS) angeordnet ist und die Verbindungsstrecke auf dem Trägersubstrat (TS) zwischen dem ersten Chip (CH1) und dem weiteren Chip (CH3) so lang ist, dass das Trägersubstrat (TS) zwischen den Chips (CH1, CH2, CH3) gebogen werden kann.

10. Bauelement nach einem der vorherigen Ansprüche, ferner umfassend auf der Oberseite des Trägersubstrats (TS) frei liegende Leiterbahnen (SL), die dazu vorgesehen sind, über eine Steckverbindung mit einer externen Schaltungsumgebung verbunden und verschaltet zu werden.

11. Verfahren zur Herstellung eines elektrischen Bauelements (B), umfassend die Schritte:
- Bereitstellen eines ersten Chips (CH1),
- Ausbilden einer metallischen Verbindungsstruktur (VBS) und einer metallischen Verschaltungsstruktur (VSS) an der Unterseite des ersten Chips (CH1), wobei die beiden Strukturen (VBS, VSS) unterschiedliche Höhen aufweisen,
- Bereitstellen eines Trägersubstrats (TS) mit einer weichen Polymerlage (TSO),
- Verbinden von erstem Chip (CH1) mit Trägersubstrat (TS), wobei die Verschaltungsstruktur (VSS) die Polymerlage (TSO) durchdringt und die Verbindungsstruktur (VBS) die Polymerlage (TSO) berührt, ohne sie zu durchdringen,
- wobei neben dem ersten Chip (CH1) noch ein weiterer Chip (CH2) auf dem Trägersubstrat (TS) angeordnet wird,
- wobei die Polymerlage (TSO) nach dem Aufsetzen des ersten Chips (CH1) und des zweiten Chips (CH2) durch Beleuchten oder Erhitzen gehärtet wird,
- wobei das Trägersubstrat (TS) unter der Polymerlage (TSO) eine weitere Schicht (TSU) umfasst und die weitere Schicht (TSU) nach dem Härten der Polymerlage (TSO) vollständig oder selektiv in Bereichen der Verschaltungsstruktur (VSS) entfernt und die Verschaltungsstruktur (VSS) freigelegt wird und
- die Verschaltungsstruktur (VSS) Kontakte (KP) umfasst,
- die Kontakte (KP) nach dem Freilegen durch Ausbilden von Leiterstrukturen (SL) auf der Unterseite des Trägersubstrats (TS) kontaktiert werden.

12. Verfahren nach dem vorherigen Anspruch,
- wobei das Trägersubstrat (TS) unter der Polymerlage (TSO) eine Schicht umfasst, die in einem geeigneten optisch Wellenlängenbereich transparent ist und das Härten der Polymerschicht (TSO) durch Belichten in diesem Wellenlängenbereich erfolgt.

13. Verfahren nach einem der vorherigen Ansprüche, wobei ein Füllmaterial (UF) in Bereichen zwischen einem Chipmaterial (CH1, CH2, CH3) und dem Trägersubstrat (TS) angeordnet wird.

14. Verfahren nach einem der vorherigen Ansprüche, wobei eine Moldmasse (VM) und/oder eine Folie (F) über dem ersten Chip (CH1) aufgebracht wird.

15. Verfahren nach einem der vorherigen Ansprüche, wobei
elektrisch leitende Strukturen (SL) an der Oberfläche des Chips (CH1) und/oder an der Oberfläche des Trägersubstrats (TS) durch Abscheiden eines Metalls oder einer Legierung oder durch Jetten von Metall umfassenden Nanopartikeln gebildet werden.

## Claims

1. Electric component (B) comprising:
- a support substrate (TS) comprising at least one polymer layer (TSO),
- a first chip (CH1) comprising a connection structure (VBS) on its underside and comprising a metallic switching structure (VSS) on its underside, wherein
- the first chip (CH1) is arranged on the support substrate (TS),
- the connection structure (VBS) rests on the polymer layer (TSO) or protrudes into the polymer layer (TSO) without penetrating through it,
- the switching structure (VSS) penetrates through the polymer layer (TSO),
- a gap between the first chip (CH1) and the support substrate (TS), wherein sensitive structures (BES) are arranged on the underside of the first chip (CH1) without touching the support substrate (TS), **characterized in that**
- a second chip (CH2), which is arranged next to and electrically contacted with the first chip (CH1) on the support substrate (TS).

2. Component according to the preceding claim, wherein the first chip (CH1) is selected from: a MEMS chip, a NEMS chip, an IC chip, an opto-electronic chip, an actuator chip, a chip comprising only passive switching elements.

3. Component according to any of the preceding claims, wherein the support substrate (TS) furthermore comprises a layer (TSU) selected from: an SESUB, a printed circuit board, an LTCC substrate, an HTCC substrate, an organic support foil, an inorganic support foil, a metal foil, a monocrystalline substrate, a polycrystalline substrate, a semiconductor substrate, a ceramic substrate, a glass substrate.

4. Component according to the preceding claim, wherein the gap is delimited laterally by the connection structure (VBS) formed as frame (R) on the underside of the chip and wherein the chip (CH1), the frame (R), and the support substrate (TS) enclose a cavity (H).

5. Component according to any of the preceding claims, wherein
- the connection structure (VBS) comprises as main component a polymer, Cu, Al, Ag, or Au, and
- the switching structure (VSS) comprises as main component Cu, Al, Ag, or Au.

6. Component according to any of the preceding claims, wherein the switching structure (VSS) comprises
- a bump connection or metallic pillars or
- a through-connection through the chip (CH1) and/or the support substrate (TS).

7. Component according to any of the preceding claims, wherein the connection structure (VBS) comprises supports having a round or rectangular cross section or supporting frames (R).

8. Component according to any of the preceding claims, further comprising
- an encapsulation with a laminate, a mold mass (VM), a mass applied by a printing method, or a foil (F) above the first chip (CH1), and/or
- a filler material (UF) arranged directly on a region of the support substrate (TS) and filling a gap between a chip material and the support substrate (TS).

9. Component according to any of the preceding claims, comprising at least one additional chip (CH3), wherein the additional chip (CH3) is arranged on the top side of the support substrate (TS) and the connecting path on the support substrate (TS) between the first chip (CH1) and the additional chip (CH3) is so long that the support substrate (TS) can be bent between the chips (CH1, CH2, CH3).

10. Component according to any of the preceding claims, further comprising, on the top side of the support substrate (TS), exposed conductor paths (SL) provided to be connected to and interconnected with an external circuit environment via a plug connection.

11. Method for producing an electric component (B), comprising the steps:
- providing a first chip (CH1),
- forming a metallic connection structure (VBS) and a metallic switching structure (VSS) on the underside of the first chip (CH1), wherein the two structures (VBS, VSS) have different heights,
- providing a support substrate (TS) comprising a soft polymer layer (TSO),
- connecting the first chip (CH1) to the support substrate (TS), wherein the switching structure (VSS) penetrates through the polymer layer (TSO) and the connection structure (VBS) touches the polymer layer (TSO) without penetrating through it,
- wherein an additional chip (CH2) is additionally arranged on the support substrate next to the first chip (CH1),
- wherein the polymer layer (TSO) is cured by exposure to light or by heating after placing the first chip (CH1),
- wherein the support substrate (TS) comprises an additional layer (TSU) underneath the polymer layer (TSO) and wherein the additional layer (TSU) is removed completely or selectively in the regions of the switching structure (VSS) after curing of the polymer layer (TSO) and wherein the switching structure (VSS) is exposed and
- the switching structure (VSS) comprises contacts (KP),
- the contacts (KP) are contacted by forming conductor structures (SL) on the underside of the support substrate (TS) after the exposing.

12. Method according to the preceding claim,
- wherein the support substrate (TS) comprises, underneath the polymer layer (TSO), a layer that is transparent in a suitable optical wavelength range and wherein the curing of the polymer layer (TSO) takes place by exposing it to light in this wavelength range.

13. Method according to any of the preceding claims, wherein a filler material (UF) is arranged in the regions between a chip material (CH1, CH2, CH3) and the support substrate (TS).

14. Method according to any of the preceding claims, wherein a mold mass (VM) and/or a foil (F) is applied over the first chip (CH1).

15. Method according to any of the preceding claims, wherein electrically conductive structures (SL) are formed on the surface of the chip (CH1) and/or on the surface of the support substrate (TS) by depositing a metal or an alloy or by jetting metal-comprising nanoparticles.

## Revendications

1. Composant (B) électrique comprenant
- un substrat de support (TS) avec au moins une couche de polymère (TSO),
- une première puce (CH1) avec une structure de liaison (VBS) sur son côté inférieur et avec une structure de branchement (VSS) métallique sur son côté inférieur,
dans lequel
- la première puce (CH1) est disposée sur le substrat de support (TS),
- la structure de liaison (VBS) repose sur la couche de polymère (TSO) ou dépasse dans la couche de polymère (TSO) sans la traverser,
- la structure de branchement (VSS) traverse la couche de polymère (TSO),
- un interstice entre la première puce (CH1) et le substrat de support (TS), dans lequel des structures sensibles (BES) sont disposées sur le côté inférieur de la première puce (CH1) sans toucher le substrat de support (TS), **caractérisé par**
- une deuxième puce (CH₂), qui est disposée à côté de la première puce (CH₁) sur le substrat de support (TS) et est en contact électrique avec la première puce (CH₁).

2. Composant selon la revendication précédente, dans lequel la première puce (CH₁) est choisie parmi : une puce MEMS, une puce NEMS, une puce IC, une puce optoélectronique, une puce d'actionneur, une puce comprenant seulement des éléments de circuit passifs.

3. Composant selon l'une des revendications précédentes, dans lequel le substrat de support (TS) comprend en outre une couche (TSU), qui est choisie parmi : un SESUB, une plaque conductrice, un substrat LTCC, un substrat HTCC, un film de support organique, un film de support inorganique, un film métallique, un substrat monocristallin, un substrat polycristallin, un substrat semi-conducteur, un substrat en céramique, un substrat en verre.

4. Composant selon la revendication précédente, dans lequel l'interstice est délimité latéralement par la structure de liaison (VBS) réalisée sur le côté inférieur de la puce en tant que cadre (R) et la puce (CH1), le cadre (R) et le substrat de support (TS) renferment un espace creux (H).

5. Composant selon l'une des revendications précédentes, dans lequel
- la structure de liaison (VBS) présente en tant que constituant principal un polymère, du Cu, de l'Al, de l'Ag ou de l'Au, et
- la structure de branchement (VSS) présente en tant que constituant principal du Cu, de l'Al, de l'Ag ou de l'Au.

6. Composant selon l'une des revendications précédentes, dans lequel la structure de branchement (VSS) comprend
- une liaison à plot ou des piliers métalliques ou
- une interconnexion traversante au travers la puce (CH1) et/ou du substrat de support (TS).

7. Composant selon l'une des revendications précédentes, dans lequel la structure de liaison (VBS) comprend des montants avec une section transversale ronde ou rectangulaire ou des cadres (R) d'appui.

8. Composant selon l'une des revendications précédentes, comprenant en outre
- un encapsulage avec un stratifié, une masse moulée (VM), une masse appliquée par un procédé d'impression ou un film (F) au-dessus de la première puce (CH₁) et/ou
- un matériau de remplissage (UF), qui est disposé directement sur une zone du substrat de support (TS) et remplit un interstice entre un matériau de puce et le substrat de support (TS).

9. Composant selon l'une des revendications précédentes, avec au moins une autre puce (CH₃), dans lequel l'autre puce (CH₃) est disposée sur le côté supérieur du substrat de support (TS) et le trajet de liaison sur le substrat de support (TS) entre la première puce (CH₁) et l'autre puce (CH₃) est suffisamment long pour que le substrat de support (TS) puisse être cintré entre les puces (CH₁, CH₂, CH₃).

10. Composant selon l'une des revendications précédentes, comprenant en outre sur le côté supérieur du substrat de support (TS) des pistes conductrices (SL) dégagées, qui sont agencées pour être reliées et branchées à un environnement de circuit externe par l'intermédiaire d'une liaison par enfichage.

11. Procédé pour fabriquer un composant (B) électrique, comprenant les étapes :
- d'obtention d'une première puce (CH₁),
- de réalisation d'une structure de liaison (VBS) métallique et d'une structure de branchement (VSS) métallique sur le côté inférieur de la première puce (CH₁),dans lequel les deux structures (VBS, VSS) présentent des hauteurs différentes,
- d'obtention d'un substrat de support (TS) avec une couche de polymère (TSO) souple,
- de liaison d'une première puce (CH₁) au substrat de support (TS), dans lequel la structure de branchement (VSS) traverse la couche de polymère (TSO) et la structure de liaison (VBS) touche la couche de polymère (TSO) sans la traverser,
- dans lequel outre la première puce (CH₁),encore une autre puce (CH₂) est disposée sur le substrat de support (TS),
- dans lequel la couche de polymère (TSO) est durcie par irradiation ou chauffage après la pose de la première puce (CH₁) et de la deuxième puce (CH₂),
- dans lequel le substrat de support (TS) comprend sous la couche de polymère (TSO) une autre couche (TSU) et l'autre couche (TSU) est supprimée totalement ou de manière sélective dans des zones de la structure de branchement (VSS) après le durcissement de la couche de polymère (TSO) et la structure de branchement (VSS) est dégagée, et
- la structure de branchement (VSS) comprend des contacts (KP),
- les contacts (KP) sont mis en contact après le dégagement en réalisant des structures conductrices (SL) sur le côté inférieur du substrat de support (TS).

12. Procédé selon la revendication précédente,
- dans lequel le substrat de support (TS) comprend sous la couche de polymère (TSO) une couche qui est transparente dans une plage de longueurs d'onde optique adaptée, et le durcissement de la couche de polymère (TSO) est effectué par exposition dans ladite plage de longueurs d'onde.

13. Procédé selon l'une des revendications précédentes, dans lequel un matériau de remplissage (UF) est disposé dans des zones entre un matériau de puce (CH₁, CH₂, CH₃) et le substrat de support (TS).

14. Procédé selon l'une des revendications précédentes, dans lequel une masse moulée (VM) et/ou un film (F) sont appliqués par-dessus la première puce (CH₁).

15. Procédé selon l'une des revendications précédentes, dans lequel
des structures électriquement conductrices (SL) sont formées sur la surface de la puce (CH₁) et/ou sur la surface du substrat de support (TS) par séparation d'un métal ou d'un alliage ou par pulvérisation de nanoparticules comprenant du métal.
